# EUROPÄISCHE PATENTANMELDUNG

(11) **EP 1 178 377 A1**
(43) Veröffentlichungstag der Anmeldung: **06.02.2002**
(21) Anmeldenummer: 00810694.0
(22) Anmeldetag: 02.08.2000
(51) Int. Cl.: G05B 17/02, G06F 17/50

(54) **Verfahren und System zum computergestützten Konfigurieren eines technischen Produkts**

(71) Anmelder: ABB RESEARCH LTD., 8050 Zürich (CH)
(72) Erfinder: Gelle, Esther, 8965 Berikon (CH); Nelissen, Josef, Dr., 5442 Fislisbach (CH); Draber, Silke, Prof., 53177 Bonn-Bad Godesberg (DE)
(74) Vertreter: ABB Patent Attorneys

(57) **Zusammenfassung**

Verfahren und System zum computergestützten Konfigurieren eines technischen Produkts, in welchen basierend auf einer Produktspezifikation eine oder mehrere Produktkonfigurationen des technischen Produkts automatisch erstellt werden, wobei die Produktkonfigurationen jeweils Komponentendaten von technischen Komponenten, die in der betreffenden Produktkonfiguration des technischen Produkts verwendet werden, und Wechselbeziehungsdaten mit Angaben über die Wechselbeziehung zwischen diesen Komponenten umfassen, wobei die Komponentendaten Lebenszyklusdaten umfassen, die jeweils Angaben über die zu erwartenden Eigenschaften einer Komponente während deren Lebenszyklus beinhalten, und wobei basierend auf den Wechselbeziehungsdaten einer Produktkonfiguration und den Lebenszyklusdaten der Komponenten dieser Produktkonfiguration Angaben bestimmt werden über die zu erwartenden Eigenschaften des dieser Produktkonfiguration entsprechenden technischen Produkts während dessen Lebenszyklus.

## Beschreibung

### Technisches Gebiet

Die vorliegende Erfindung betrifft ein Verfahren und ein System zum computergestützten Konfigurieren eines technischen Produkts aus technischen Komponenten. Insbesondere betrifft die vorliegende Erfindung ein Verfahren und ein System zum computergestützten Konfigurieren eines technischen Produkts gemäss dem Oberbegriff des unabhängigen Verfahrensanspruchs, beziehungsweise gemäss dem Oberbegriff des unabhängigen Systemanspruchs.

### Stand der Technik

Systeme zum computergestützten Konfigurieren eines technischen Produkts aus technischen Komponenten, insbesondere elektrische, mechanische, elektromechanische oder elektronische Komponenten, sind bekannt. Zum besseren Verständnis soll gleich eingangs festgehalten werden, dass im vorliegenden Text mit dem Begriff "technisches Produkt" auch technische Systeme gemeint sind und dass mit dem Begriff "technische Komponente" in entsprechender Weise nicht nur diskrete technische Bauteile sondern auch technische Subsysteme, Module und Verbindungsteile und Schnittstellen gemeint sind. Solche herkömmlichen Konfigurationssysteme, die auch als Konfiguratoren bezeichnet werden, sind typischerweise programmierte Softwareapplikationen, die an spezifische Benutzeranforderungen anpassbar sind, die auf einem oder mehreren Computern ausgeführt werden und die typischerweise eine Datenbank mit darin gespeicherten Informationen über Komponenten (Komponentendaten) umfassen, respektive Zugang zu einer solchen Datenbank haben. Als Beispiele für bekannte Konfigurationssysteme sollen hier nicht abschliessend Konfiguratoren der Firmen SAP (Sales Configuration Engine, Teil von SAP R/3 Release 4.5), Trilogy (MCC Configurator, Teil von MultiChannelCommerce MCC 2.0), Baan (E-Configuration 2.2) oder Tacton (Tacton Configurator) erwähnt werden. In diesen computergestützten Konfigurationssystemen wird die Spezifikation eines technischen Produkts durch einen oder mehrere Benutzer dadurch definiert, dass Anforderungen, insbesondere funktionale und qualitative Anforderungen, an das technische Produkt über eine Schnittstelle des Konfigurationssystems eingegeben und im Konfigurationssystem erfasst werden. Basierend auf den erfassten Anforderungen wird im Konfigurationssystem eine auf diesen Anforderungen basierende Produktspezifikation des zu konfigurierenden technischen Produkts bestimmt und auf der Grundlage dieser Produktspezifikation automatisch eine oder mehrere Produktkonfigurationen des technischen Produkts erstellt. Die durch bekannte Konfigurationssysteme erstellten Produktkonfigurationen umfassen jeweils Informationen über die technischen Komponenten, die in der betreffenden Produktkonfiguration des technischen Produkts verwendet werden, sowie Informationen über die für die Funktionstüchtigkeit des technischen Produkts benötigten Wechselbeziehungen zwischen diesen technischen Komponenten, das heisst Informationen über den Zusammenschluss und/oder die Verbindung der technischen Komponenten zu einer funktionstüchtigen Konfiguration des technischen Produkts. Je nach Verwendung oder Ausführung des Konfigurationssystems wird nur eine Produktkonfiguration des technischen Produkts bestimmt oder es werden sämtliche möglichen Produktkonfiguration des technischen Produkts bestimmt, die den erfassten Anforderungen an das technische Produkt, respektive der entsprechenden Produktspezifikation, genügen, und die sich unter Berücksichtigung der Wechselbeziehungen zwischen den verwendeten technischen Komponenten als funktionstüchtig erweisen. Eine Produktkonfiguration, die die technischen Komponenten angibt, aus denen das technische Produkt besteht, und die die Wechselbeziehungen zwischen diesen technischen Komponenten angibt, wird auch als Konfigurationsmodell bezeichnet, das als Grundlage zur Überprüfung der Funktionstüchtigkeit des betreffenden technischen Produkts verwendet wird. In herkömmlichen Konfigurationssystemen werden teilweise auch zusätzliche Zielfunktionen verwendet, mittels welchen Produktkonfiguration hinsichtlich vordefinierten Zielgrössen optimiert werden können. Als Zielgrössen können in solchen Konfigurationssystemen beispielsweise die Herstellungskosten oder die Anzahl verwendeter Komponenten des technischen Produkts definiert werden. Die bekannten Konfigurationssysteme weisen jedoch den Nachteil auf, dass sie auf den Entwurf von funktionstüchtigen technischen Produkten aus technischen Komponenten begrenzt sind, wobei dieser Entwurf allenfalls hinsichtlich der Herstellung, beispielsweise hinsichtlich Herstellungskosten oder Anzahl verwendeter Komponenten, optimiert wird, wobei aber durch die bekannten Konfigurationssysteme keine Aspekte berücksichtigt werden, die über den Entwurf oder die Herstellung des funktionstüchtigen technischen Produkts hinausgehen.

### Darstellung der Erfindung

Es ist eine Aufgabe der vorliegenden Erfindung, ein neues und besseres Verfahren sowie ein neues und besseres System zum computergestützten Konfigurieren eines technischen Produkts vorzuschlagen, welche insbesondere nicht den Nachteil des Stands der Technik aufweisen.

Gemäss der vorliegenden Erfindung werden diese Ziele insbesondere durch die Elemente der unabhängigen Ansprüche erreicht. Weitere vorteilhafte Ausführungsformen gehen ausserdem aus den abhängigen Ansprüchen und der Beschreibung hervor.

Diese Ziele werden durch die vorliegende Erfindung insbesondere dadurch erreicht, dass die Informationen über technische Komponenten, die Komponentendaten, die beispielsweise in einer Datenbank gespeichert sind, zusätzlich Lebenszyklusdaten umfassen, die jeweils Informationen über die zu erwartenden Eigenschaften einer betreffenden Komponente während deren Lebenszyklus enthalten, und dass diese Lebenszyklusdaten bei der automatischen Erstellung der Produktkonfigurationen jeweils miteinbezogen werden. Dabei werden basierend auf den Informationen über die Wechselbeziehungen zwischen den verwendeten technischen Komponenten, das heisst den Wechselbeziehungsdaten einer Produktkonfiguration, die beispielsweise aus den Komponentendaten hergeleitet werden, und basierend auf den Lebenszyklusdaten der verwendeten Komponenten Angaben über die während des Lebenszyklus des technischen Produkts zu erwartenden Eigenschaften bestimmt. Der Vorteil der Verwendung von Lebenszyklusdaten bei der Erstellung der Produktkonfigurationen besteht darin, dass die Produktkonfigurationen auch hinsichtlich Parametern optimiert werden können, die über die Entwurfs- und/oder Herstellungsphase des funktionstüchtigen technischen Produkts hinausgehen, so dass technische Produkte hinsichtlich deren Lebenszyklus optimal konfiguriert werden können.

Vorzugsweise umfassen die Lebenszyklusdaten Ausfalldaten, die Informationen über Ausfallarten von Komponenten und über diesen Ausfallarten zugeordnete Ausfallraten enthalten. Basierend auf diesen Ausfalldaten und den Wechselbeziehungsdaten werden im Konfigurationssystem vorzugsweise Informationen über zu erwartende Folgewirkungen von Ausfällen einzelner oder mehrerer Komponenten auf das technische Produkt bestimmt. Die Informationen über zu erwartende Folgewirkungen umfassen beispielsweise Informationen über Folgeausfälle, die als Konsequenz von Ausfällen einzelner oder mehrerer Komponenten resultieren. Der Vorteil der Verwendung von Ausfalldaten bei der Erstellung der Produktkonfigurationen besteht darin, dass die Produktkonfigurationen hinsichtlich Folgewirkungen von Ausfällen einzelner oder mehrerer Komponenten auf das technische Produkt optimiert werden können.

In einer Ausführungsvariante umfassen die Ausfalldaten Reparaturdaten mit Angaben über Reparaturart und/oder Reparaturmaterial und/oder Reparatursachkenntnisse, die jeweils zur Behebung eines Ausfalls erforderlich sind, und basierend auf diesen Reparaturdaten werden zu erwartende Reparaturaufwände für das technische Produkt bestimmt. Der Vorteil der Verwendung von Reparaturdaten bei der Erstellung der Produktkonfigurationen besteht darin, dass die Produktkonfigurationen hinsichtlich der zu erwartenden Reparaturaufwände für das technische Produkt und insbesondere der damit verbundenen Kosten optimiert werden können.

### Kurze Beschreibung der Zeichnungen

Nachfolgend wird eine Ausführung der vorliegenden Erfindung anhand eines Beispieles beschrieben. Das Beispiel der Ausführung wird durch folgende einzige beigelegte Figur illustriert:

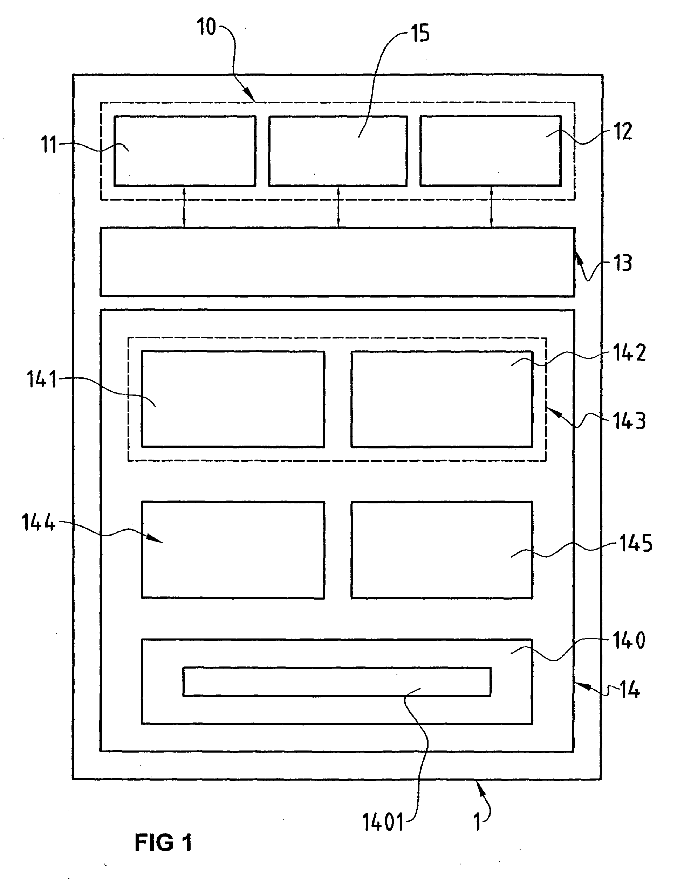

Figur 1 zeigt ein Blockdiagramm, welches schematisch ein Konfigurationssystem darstellt, das ein Konfigurationsmodul, ein Optimierungsmodul sowie eine Datenbank mit darin gespeicherten Komponentendaten, Lebenszyklusdaten und Anforderungsdaten sowie Konfigurationsmodellen und Lebenszyklusmodellen umfasst.

### Wege zur Ausführung der Erfindung

In der Figur 1 bezieht sich die Bezugsziffer 1 auf ein Konfigurations-system, das ein Konfigurationsmodul 11 und ein Optimierungsmodul 12 umfasst, die mittels einer Datenbankschnittstelle 13, beispielsweise eine ODBC-(Open Database Connectivity) oder eine JDBC-Datenbankschnittstelle (Java Database Connectivity), auf eine Datenbank 14 zugreifen. Das Konfigurationsmodul 11 und das Optimierungsmodul 12 sind programmierte Softwaremodule, die beispielsweise auf einem separaten Arbeitsplatzrechner ausgeführt werden und mittels der Datenbankschnittstelle 13 über eine Netzwerkverbindung, beispielsweise ein Local Area Network, auf die Datenbank 14 zugreifen, die beispielsweise auf einem herkömmlichen Server Computer mit Betriebssystem implementiert ist. Das Konfigurationsmodul 11 und das Optimierungsmodul 12 können auch auf dem gleichen Computer ausgeführt werden wie die Datenbank 14. Das Konfigurationsmodul 11 und das Optimierungsmodul 12 können in separaten Applikationen oder in einer gemeinsamen Applikation 10 ausgeführt sein. Das Konfigurationsmodul 11 basiert beispielsweise auf einem eingangs erwähnten herkömmlichen Konfigurator, der mit zusätzlichen Softwarefunktionen erweitert wird. Das Optimierungsmodul 12 basiert beispielsweise auf einer herkömmlichen Optimierungs-Softwareapplikation, beispielsweise dem Availability and Life Cycle Cost Tool (ALTO, Version 3.0) der Firma ABB. Die Datenbank 14 basiert zum Beispiel auf einem herkömmlichen, beispielsweise relationalen, Datenbankmanagementsystem (DBMS) oder sie ist als proprietäres System implementiert, das beispielsweise auch Bestandteil der Applikation 10, respektive 11 und/oder 12, sein kann (nicht dargestellt).

Wie in der Figur 1 schematisch dargestellt ist, enthält die Datenbank 14 Komponentendaten 140, benutzerspezifizierte Produkteanforderungen 145, Konfigurationsmodelle 141, Lebenszyklusmodelle 142 sowie optimierte Produktekonfigurationen 144, wobei die Konfigurationsmodelle 141 und Lebenszyklusmodelle 142 beispielsweise jeweils auch in einem Konfigurationsmodell mit Lebenszyklusdaten 143 kombiniert sein können und wobei die Komponentendaten 140 in einer alternativen Ausführung in einer separaten Komponenten-Datenbank gespeichert sein können.

Die Komponentendaten 140 sind beispielsweise in einer Komponentendatentabelle gespeichert, wobei die Komponentendaten 140 für eine bestimmte Komponente jeweils eine Komponentenidentifizierung, einen Komponententyp, eine Komponenteninstanzierung sowie Wechselbeziehungsdaten mit Angaben über die Wechselbeziehung des betreffenden Komponententyps mit anderen Komponententypen umfassen. Der Komponententyp definiert einen bestimmten Typ von Komponenten (z.B. ein Circuit Breaker), beispielsweise durch einen Satz von für diesen Komponententyp charakteristischen Komponentenattributen. Die Komponenteninstanzierung definiert eine konkrete Instanzierung eines betreffenden Komponententyps durch Werte für die Komponentenattribute des betreffenden Komponententyps. Die Wechselbeziehungsdaten umfassen insbesondere Angaben über Wechselbeziehungen zwischen Komponententypen in einer Produktstruktur, das heisst Anforderungen und Einschränkungen hinsichtlich der Verbindung und/oder Zusammenschaltung des betreffenden Komponententyps mit anderen Komponententypen bei der Konfiguration eines technischen Produkts. Die Komponentendaten 140 können beispielsweise in einem Format gespeichert werden, das von herkömmlichen Konfiguratoren unterstützt wird oder das in ein von herkömmlichen Konfiguratoren unterstütztes Format transformierbar ist.

Wie aus der Figur 1 ersichtlich ist, umfassen die Komponentendaten 140 zusätzlich auch Lebenszyklusdaten 1401, die Angaben über die zu erwartenden Eigenschaften einer betreffenden Komponente (ein Komponententyp oder eine Komponenteninstanzierung) während deren Lebenszyklus umfassen. Die Lebenszyklusdaten 1401 sind zusätzliche Datenelemente, die den jeweils betreffenden Komponenten zugeordnet in der Komponentendatentabelle oder in einer separaten Lebenszykluskomponentendatentabelle gespeichert sind. Die Lebenszyklusdaten 1401 umfassen Ausfallarten (failure modes) von Komponenten sowie diesen Ausfallarten entsprechende Ausfallraten (failure rates), die beispielsweise jeweils als Wahrscheinlichkeit oder durchschnittlicher Erfahrungswert eines Ausfalls der betreffenden Ausfallsart für vordefinierte Zeitperioden, oder als durchschnittliche zu erwartende ausfallfreie Zeitdauer insgesamt und/oder für bestimmte Ausfallsarten angegeben sind. Die Lebenszyklusdaten 1401 umfassen zudem den Ausfalldaten zugeordnete Reparaturdaten mit Angaben über Reparaturart und/oder Reparaturmaterial und/oder Reparatursachkenntnisse, die jeweils zur Behebung eines Ausfalls der betreffenden Ausfallart erforderlich sind (die Reparaturdaten können beispielsweise als Bestandteil der Ausfalldaten gespeichert sein). Den Ausfalldaten können auch Angaben über konkrete Auswirkungen von Ausfällen von Komponenteninstanzierungen zugeordnet sein.

Die benutzerspezifizierten Produkteanforderungen 145 sind beispielsweise in einer Anforderungsdatentabelle gespeichert und umfassen zusätzlich zu den Anforderungsdaten, die in herkömmlichen Konfigurations-systemen verwendet werden, Angaben über Produktzuverlässigkeit, respektive Produktausfälle, beispielsweise Ausfallarten und entsprechende Ausfallraten, und/oder Angaben über Produktwartung, beispielsweise Wartungstypen und entsprechende Wartungskosten und Wartungsfrequenzen. Die Produkteanforderungen 145 werden mittels Spezifizierungsmitteln von Benutzern erfasst und in der Datenbank 14 gespeichert. Die Spezifizierungsmittel sind typischerweise programmierte Softwarefunktionen, auf die von Benutzern beispielsweise über eine GUI-Benutzerschnittstelle (Graphical User Interface) zugegriffen werden kann. Die Spezifizierungsmittel sind beispielsweise Bestandteil des Konfigurationsmoduls 11 oder sie können als separate Applikation ausgeführt werden.

Insbesondere für Kostenoptimierungszwecke umfassen die Komponentendaten 140 zudem Kostenangaben, die sich auf die Kosten von Komponenteninstanzierungen, Kosten von Ausfällen verschiedener Ausfallarten von Komponenteninstanzierungen, Kosten von Folgewirkungen von Ausfällen von Komponenteninstanzierungen, Kosten der Reparatur von Ausfällen von Komponenteninstanzierungen und/oder Kosten der Wartung von Komponenteninstanzierungen beziehen.

Die Konfigurationsmodelle 141 sind beispielsweise in einer Konfigurationsdatentabelle gespeichert und umfassen jeweils Identifizierungen der technischen Komponenten, aus denen das konfigurierte technische Produkt besteht, und/oder deren Komponententypen, Komponenteninstanzierungen sowie Wechselbeziehungsdaten, die bereits im Zusammenhang mit den Komponentendaten 140 erwähnt wurden. Die Konfigurationsmodelle 141 umfassen insbesondere auch Wechselbeziehungsdaten mit Angaben über die Wechselbeziehungen zwischen den Komponenteninstanzierungen des konfigurierten technischen Produkts, beispielsweise Identifizierungen von verbundenen Komponenteninstanzierungen und Angaben über die Verbindung und/oder die Zusammenschaltung mit diesen Komponenteninstanzierungen. Das Konfigurationsmodell 141 einer Produktkonfiguration dient dem Konfigurationsmodul 11 als Grundlage zur Überprüfung der Funktionstüchtigkeit des betreffenden technischen Produkts.

Die Lebenszyklusmodelle 142 sind jeweils einem betreffenden Konfigurationsmodell 141 zugeordnet in einer separaten Lebenszyklusdatentabelle oder als zusätzliche Datenelemente in der Konfigurationsdatentabelle gespeichert. Die Lebenszyklusmodelle 142 umfassen jeweils Angaben über die zu erwartenden Eigenschaften des der betreffenden Produktkonfiguration entsprechenden technischen Produkts während dessen Lebenszyklus. Diese Angaben über die zu erwartenden Lebenszykluseigenschaften des konfigurierten technischen Produkts werden durch programmierte Softwarefunktionen auf Grund der oben erwähnten Lebenszyklusdaten 1401 der in der Konfiguration des technischen Produkts verwendeten Komponenten (Komponententypen und Komponenteninstanzierungen) und unter Berücksichtigung der Wechselbeziehungsdaten betreffend die Wechselbeziehungen zwischen diesen Komponenten bestimmt. Diese programmierten Softwarefunktionen sind beispielsweise in einem FMEA-Modul 15 (Failure Modes and Effects Analysis) ausgeführt, das als separates Applikationsmodul oder als Zusatzmodul zum Konfigurationsmodul 11 implementiert ist. Mittels der Softwarefunktionen des FMEA-Moduls 15 werden die Ausfallarten (und Ausfallraten) der verwendeten Komponenten (Komponententyp und Komponenteninstanzierung) hinsichtlich deren Auswirkung auf das konfigurierte technische Produkt analysiert. Mittels der Softwarefunktionen des FMEA-Moduls 15 können so Folgewirkungen von Ausfällen einzelner oder mehrerer Komponenten auf das technische Produkt bestimmt werden, wobei es insbesondere auch möglich ist, Folgeausfälle von Komponenten zu bestimmen, die als Konsequenz von vorhergehenden Ausfällen einzelner oder mehrerer Komponenten resultieren. Das FMEA-Modul 15 kann beispielsweise mit Deduktionsfunktionen ausgestattet werden, die beispielsweise in herkömmlichen AI-Modulen (Artificial Intelligence) verfügbar sind. Auf Grund der durch die Softwarefunktionen des FMEA-Moduls 15 durchgeführten Analyse werden im Lebenszyklusmodell 142 eines konfigurierten technischen Produkts zusätzlich zu den Angaben über die Ausfallarten und die entsprechenden Ausfallraten der verwendeten Komponenten, die bereits im Zusammenhang mit den Lebenszyklusdaten 1401 erwähnt wurden, Angaben hinsichtlich der Auswirkung der Ausfälle einzelner oder mehrerer Komponenten auf das konfigurierte technische Produkt sowie Angaben über Folgeausfälle von Komponenten, die als Konsequenz von vorhergehenden Ausfällen einzelner oder mehrerer Komponenten resultieren, gespeichert. Zusätzlich können im Lebenszyklusmodell 142 eines konfigurierten technischen Produkts Angaben über Reparaturart und/oder Reparaturmaterial und/oder Reparatursachkenntnisse, die jeweils zur Behebung eines Ausfalls der betreffenden Ausfallart erforderlich sind, sowie Angaben betreffend die Kosten von Komponenteninstanzierungen, Kosten von Ausfällen verschiedener Ausfallarten von Komponenteninstanzierungen, Kosten von Folgewirkungen von Ausfällen von Komponenteninstanzierungen, Kosten der Reparatur von Ausfällen von Komponenteninstanzierungen und/oder Kosten der Wartung von Komponenteninstanzierungen gespeichert werden. Mittels der Softwarefunktionen des FMEA-Moduls 15 werden also basierend auf den Lebenszyklusdaten 1401 der in der Konfiguration des technischen Produkts verwendeten Komponenten und den Wechselbeziehungsdaten betreffend die Wechselbeziehungen zwischen diesen Komponenten der zu erwartende Reparatur- und Wartungsaufwand, insbesondere die daraus entstehenden Kosten, für das technische Produkt bestimmt und im betreffenden Lebenszyklusmodell 142 gespeichert.

Durch das Optimierungsmodul 12 können Konfigurationen eines technischen Produkts auf der Grundlage der entsprechenden Konfigurationsmodelle 141 und Lebenszyklusmodelle 142 optimiert werden, wobei als Optimierungskriterien einerseits die benutzerspezifizierten Produkteanforderungen 145 und andererseits allgemeine, untereinander durch den Benutzer prioritisierbare Kriterien, wie niedere Herstellungskosten, niedere Ausfallraten, niedere Wartungskosten und/oder niedere Ausfall- und Reparaturkosten verwendet werden können. Auf der Grundlage der Lebenszyklusmodelle 142 können zudem auch Informationen über die Eigenschaften hinsichtlich des Lebenszyklus von (bereits) bestehenden technischen Produkten bestimmt, und darauf basierend Wartungsstrategien und -pläne bestimmt werden.

Die optimierten Produktekonfigurationen 144 sind beispielsweise in einer Produktekonfigurationstabelle gespeichert und umfassen die Datenelemente des Konfigurationsmodells 141 und des zugehörigen Lebenszyklusmodells 142.

In den Lebenszyklusmodellen 142 (respektive in den Produktekonfigurationstabellen von optimierten Produktekonfigurationen 144) von konfigurierten technischen Produkten können zudem auch Wartungsdaten gespeichert werden, die Angaben über den aktuellen Zustand des realisierten und implementierten technischen Produkts, insbesondere der einzelnen Komponenten des technischen Produkts enthalten. Die Wartungsdaten können beispielsweise vom Wartungspersonal mittels Kommunikationsendgeräten on-line oder off-line über eine Festnetz- oder Mobilfunknetz-Kommunikationsverbindung an die Datenbank 14 übertragen werden. Auf der Grundlage dieser Wartungsdaten können, beispielsweise durch weitere Softwarefunktionen des FMEA-Moduls 15, Ausfallraten der im betreffenden technischen Produkt verwendeten Komponenten gezielt im Bezug zu der Struktur der Konfiguration des betreffenden technischen Produkts berechnet und gespeichert werden.

Das hier vorgeschlagene Konfigurationsverfahren, respektive das hier vorgeschlagene Konfigurationssystem 1, hat insbesondere den Vorteil, dass technische Produkte hinsichtlich deren Lebenszyklus optimal konfiguriert werden können. Das hier vorgeschlagene Konfigurationsverfahren, respektive das hier vorgeschlagene Konfigurationssystem 1, ist nicht für ein spezifisches Anwendungsgebiet oder eine spezifische Produktegruppe definiert, da die Konfigurationsmodelle 141 und Lebenszyklusmodelle 142 die Konfigurationsdaten und Lebenszyklusdaten von konfigurierten technischen Produkten auf einer Zwischenstufe (Meta-Level) mit generischen Datenelementen und Datentypen definieren. So werden beispielsweise (Klassen von) Komponenten durch einen Komponententyp und diesem Komponententyp zugeordnete Komponentenattribute definiert und eine spezifische Komponente (einer Klasse von Komponenten) ist durch eine Komponenteninstanzierung mit konkreten Werten für diese Komponentenattribute definiert. Durch diese generisch definierbaren Konfigurationsmodelle 141 und Lebenszyklusmodelle 142 können Produktekonfigurationen unabhängig von spezifischen Anwendungsgebieten oder Produktegruppen hinsichtlich deren Lebenszyklus optimiert werden. Die Optimierung von Produktekonfigurationen hinsichtlich deren Lebenszyklus hat insbesondere den Vorteil, dass Schwachstellen der Produktekonfiguration, insbesondere Schwachstellen hinsichtlich Ausfällen und Wartungsaufwand, vor der eigentlichen Realisierung und Installierung des betreffenden technischen Produkts erkannt werden können. Zudem ermöglichen diese generisch definierbaren Konfigurationsmodelle 141 und Lebenszyklusmodelle 142 standardisierte Anfragen an die Datenbank 14 zu stellen.

Als Beispiele für technische Produkte, die durch das vorgeschlagene Konfigurationsverfahren, respektive Konfigurationssystem 1, optimal konfiguriert werden können, sollen hier insbesondere Hochspannungsschalter sowie ganze Schaltanlagen für Mittel- und Hochspannungsnetze angeführt werden.

### Bezugszeichenliste

- 1: Konfigurationssystem
- 10: Applikation mit Konfigurationsmodul und Optimierungsmodul
- 11: Konfigurationsmodul
- 12: Optimierungsmodul
- 13: Datenbankschnittstelle
- 14: Datenbank
- 15: FMEA-Modul (Failure Modes and Effects Analysis)
- 140: Komponentendaten
- 141: Konfigurationsmodell
- 142: Lebenszyklusmodell
- 143: Konfigurationsmodell mit Lebenszyklusdaten
- 144: optimierte Produktekonfigurationen
- 145: Produkteanforderungen
- 1401: Lebenszyklusdaten

## Patentansprüche

1. Verfahren zum computergestützten Konfigurieren eines technischen Produkts, in welchem Verfahren eine Produktspezifikation des technischen Produkts durch die Erfassung von Anforderungen an das technische Produkt definiert wird, in welchem Verfahren basierend auf der Produktspezifikation eine oder mehrere Produktkonfigurationen des technischen Produkts automatisch erstellt werden, wobei die Produktkonfigurationen jeweils Komponentendaten von technischen Komponenten, die in der betreffenden Produktkonfiguration des technischen Produkts verwendet werden, und Wechselbeziehungsdaten mit Angaben über die Wechselbeziehung zwischen diesen Komponenten umfassen, **dadurch gekennzeichnet,**
**dass** die Komponentendaten Lebenszyklusdaten umfassen, welche Lebenszyklusdaten jeweils Angaben über die zu erwartenden Eigenschaften einer Komponente während deren Lebenszyklus beinhalten, und
**dass** basierend auf den Wechselbeziehungsdaten einer Produktkonfiguration und den Lebenszyklusdaten der Komponenten dieser Produktkonfiguration Angaben bestimmt werden über die zu erwartenden Eigenschaften des dieser Produktkonfiguration entsprechenden technischen Produkts während dessen Lebenszyklus.

2. Verfahren gemäss Anspruch 1, **dadurch gekennzeichnet, dass** die Lebenszyklusdaten Ausfalldaten umfassen, welche Ausfalldaten Angaben über Ausfallarten von Komponenten und diesen Ausfallarten zugeordnete Ausfallraten enthalten, und dass basierend auf den Ausfalldaten und den Wechselbeziehungsdaten Angaben über zu erwartende Folgewirkungen von Ausfällen einzelner oder mehrerer Komponenten auf das technische Produkt bestimmt werden.

3. Verfahren gemäss Anspruch 2, **dadurch gekennzeichnet, dass** die Angaben über zu erwartende Folgewirkungen Angaben über Folgeausfälle umfassen, die als Konsequenz von Ausfällen einzelner oder mehrerer Komponenten resultieren.

4. Verfahren gemäss einem der Ansprüche 2 oder 3, **dadurch gekennzeichnet, dass** die Ausfalldaten Reparaturdaten mit Angaben über Reparaturart und/oder Reparaturmaterial und/oder Reparatursachkenntnisse, die jeweils zur Behebung eines Ausfalls erforderlich sind, umfassen, und dass basierend auf den Reparaturdaten zu erwartende Reparaturaufwände für das technische Produkt bestimmt werden.

5. Verfahren gemäss einem der Ansprüche 1 bis 4, **dadurch gekennzeichnet, dass** die Komponentendaten Kostenangaben umfassen, die sich auf die Kosten spezifischer Komponenten, Kosten von Ausfällen verschiedener Ausfallarten von spezifischen Komponenten, Kosten von Folgewirkungen von Ausfällen spezifischer Komponenten, Kosten der Reparatur von Ausfällen spezifischer Komponenten und/oder Kosten der Wartung spezifischer Komponenten beziehen, und dass basierend auf diesen Kostenangaben zu erwartende Kosten des technischen Produkts während dessen Lebenszyklus bestimmt werden.

6. System zum computergestützten Konfigurieren eines technischen Produkts, umfassend: mindestens einen Computer mit einem Betriebssystem, Spezifizierungsmittel zur Erfassung von Anforderungen an das technische Produkt und zur Erstellung einer auf diesen Anforderungen basierenden Produktspezifikation des technischen Produkts, ein Konfigurationsmodul zur automatischen Erstellung einer oder mehrerer Produktkonfigurationen des technischen Produkts basierend auf der Produktspezifikation, wobei die Produktkonfigurationen jeweils Komponentendaten von technischen Komponenten, die in der betreffenden Produktkonfiguration des technischen Produkts verwendet werden, und Wechselbeziehungsdaten mit Angaben über die Wechselbeziehung zwischen diesen Komponenten umfassen, **dadurch gekennzeichnet,**
**dass** die Komponentendaten Lebenszyklusdaten umfassen, welche Lebenszyklusdaten jeweils Angaben über die zu erwartenden Eigenschaften einer Komponente während deren Lebenszyklus beinhalten, und
**dass** das System Mittel umfasst zur Bestimmung, basierend auf den Wechselbeziehungsdaten einer Produktkonfiguration und den Lebenszyklusdaten der Komponenten dieser Produktkonfiguration, von Angaben über die zu erwartenden Eigenschaften des dieser Produktkonfiguration entsprechenden technischen Produkts während dessen Lebenszyklus.

7. System gemäss Anspruch 6, **dadurch gekennzeichnet, dass** die Lebenszyklusdaten Ausfalldaten umfassen, welche Ausfalldaten Angaben über Ausfallarten von Komponenten und diesen Ausfallarten zugeordnete Ausfallraten enthalten, und dass das System Mittel umfasst zur Bestimmung, basierend auf den Ausfalldaten und den Wechselbeziehungsdaten, von Angaben über zu erwartende Folgewirkungen von Ausfällen einzelner oder mehrerer Komponenten auf das technische Produkt.

8. System gemäss Anspruch 7, **dadurch gekennzeichnet, dass** die Angaben über zu erwartende Folgewirkungen Angaben über Folgeausfälle umfassen, die als Konsequenz von Ausfällen einzelner oder mehrerer Komponenten resultieren.

9. System gemäss einem der Ansprüche 7 oder 8, **dadurch gekennzeichnet, dass** die Ausfalldaten Reparaturdaten mit Angaben über Reparaturart und/oder Reparaturmaterial und/oder Reparatursachkenntnisse, die jeweils zur Behebung eines Ausfalls erforderlich sind, umfassen, und dass das System Mittel umfasst zur Bestimmung, basierend auf den Reparaturdaten, von zu erwartendem Reparaturaufwand für das technische Produkt.

10. System gemäss einem der Ansprüche 6 bis 9, **dadurch gekennzeichnet, dass** die Komponentendaten Kostenangaben umfassen, die sich auf die Kosten spezifischer Komponenten, Kosten von Ausfällen verschiedener Ausfallarten von spezifischen Komponenten, Kosten von Folgewirkungen von Ausfällen spezifischer Komponenten, Kosten der Reparatur von Ausfällen spezifischer Komponenten und/oder Kosten der Wartung spezifischer Komponenten beziehen, und dass das System Mittel umfasst zur Bestimmung von zu erwartenden Kosten des technischen Produkts während dessen Lebenszyklus, basierend auf diesen Kostenangaben.
